# EUROPEAN PATENT APPLICATION

(11) **EP 4 440 275 A1**
(43) Date of publication of application: **02.10.2024**
(21) Application number: 23211943.8
(22) Date of filing: 24.11.2023
(51) Int. Cl.: H10B 10/00, H01L 21/8234, H01L 29/775

(54) **BURIED LOW-K DIELECTRIC TO PROTECT SOURCE/DRAIN TO GATE CONNECTION**

(30) Priority: 31.03.2023 US 202318129717
(71) Applicant: INTEL Corporation, Santa Clara, CA 95054 (US)
(72) Inventor: Huang, Chiao-Ti, Portland, 97229 (US); Matsubayashi, Akitomo, Beaverton, 97006 (US); Greene, Brian, Portland, 97229 (US); Lin, Chung-Hsun, Portland, 97229-8401 (US)
(74) Representative: Goddar, Heinz J.

(57) **Abstract**

An apparatus comprising a source or drain of a field effect transistor (FET), a first dielectric between a portion of the source or drain and a FET gate, the first dielectric comprising silicon nitride, and a second dielectric above at least a portion of the first dielectric, the second dielectric comprising silicon oxide doped with at least one of oxygen or carbon, the second dielectric having a dielectric constant lower than the first dielectric.

## Description

### BACKGROUND

Chemical etching is a process used in semiconductor manufacturing. Chemical etching may include usage of a chemical solution to selectively remove material from a surface in order to create a desired pattern or shape. The surface is first coated with a resist material that is resistant to the etching solution, except in the areas where the pattern or shape is desired. The resist is then exposed to a mask or template that defines the pattern or shape, and the exposed resist is removed to reveal the areas where the etching solution can penetrate and remove the underlying material. In some instances, chemical etching may remove excessive material and introduce unwanted open circuits in an integrated circuit device.

### BRIEF DESCRIPTION OF THE DRAWINGS

FIG. 1 is a static random access memory (SRAM) cell, in accordance with any of the embodiments disclosed herein.
FIG. 2 is an example source/drain (S/D) to gate connection, in accordance with any of the embodiments disclosed herein.
FIG. 3 is a cross section of a portion of an SRAM cell comprising an S/D to gate connection and a cross section of other logic integrated with the SRAM cell, in accordance with any of the embodiments disclosed herein.
FIGs. 4 illustrates phases of manufacturing of an S/D to gate connection and logic integrated with the S/D to gate connection, in accordance with any of the embodiments disclosed herein.
FIG. 5 illustrates further phases of manufacturing of an S/D to gate connection and logic integrated with the S/D to gate connection, in accordance with any of the embodiments disclosed herein.
FIG. 6 illustrates further phases of manufacturing of an S/D to gate connection and logic integrated with the S/D to gate connection, in accordance with any of the embodiments disclosed herein.
FIG. 7 illustrates further phases of manufacturing of an S/D to gate connection and logic integrated with the S/D to gate connection, in accordance with any of the embodiments disclosed herein.
FIG. 8 illustrates further phases of manufacturing of an S/D to gate connection and logic integrated with the S/D to gate connection, in accordance with any of the embodiments disclosed herein.
FIG. 9 illustrates further phases of manufacturing of an S/D to gate connection and logic integrated with the S/D to gate connection, in accordance with any of the embodiments disclosed herein.
FIG. 10 illustrates further phases of manufacturing of an S/D to gate connection and logic integrated with the S/D to gate connection, in accordance with any of the embodiments disclosed herein.
FIG. 11 illustrates further phases of manufacturing of an S/D to gate connection and logic integrated with the S/D to gate connection, in accordance with any of the embodiments disclosed herein.
FIG. 12 is a top view of a wafer and dies that may be included in a microelectronic assembly, in accordance with any of the embodiments disclosed herein.
FIG. 13 is a cross-sectional side view of an integrated circuit device that may be included in a microelectronic assembly, in accordance with any of the embodiments disclosed herein.
FIGS. 14A-14D are perspective views of example planar, FinFET, gate-all-around, and stacked gate-all-around transistors.
FIG. 15 is a cross-sectional side view of an integrated circuit device assembly that may include a microelectronic assembly, in accordance with any of the embodiments disclosed herein.
FIG. 16 is a block diagram of an example electrical device that may include a microelectronic assembly, in accordance with any of the embodiments disclosed herein.

### DETAILED DESCRIPTION

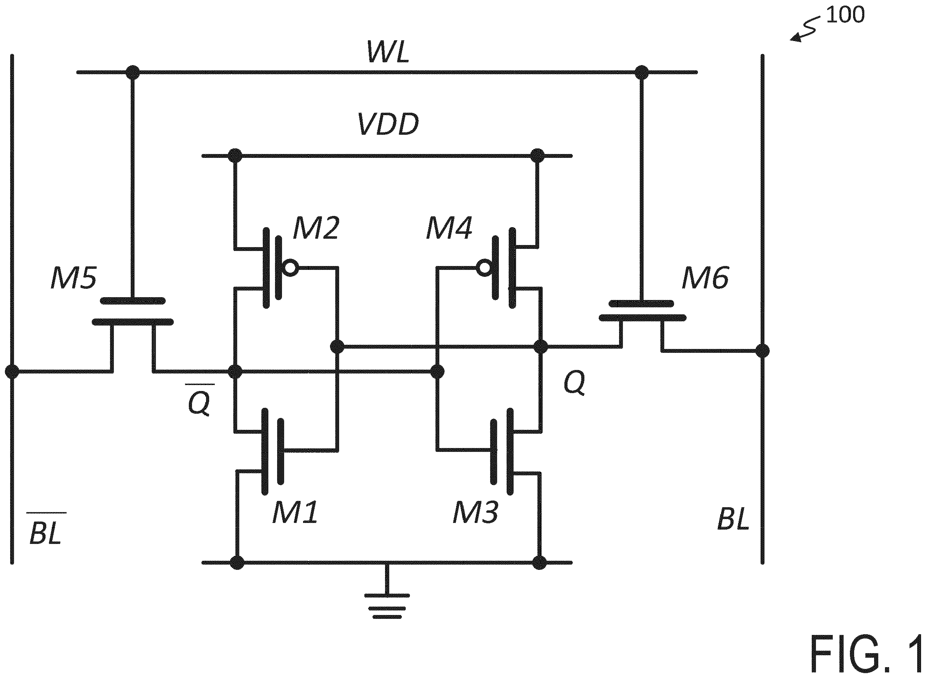

FIG. 1 is a static random access memory cell 100, in accordance with any of the embodiments disclosed herein. The memory cell comprises six field effect transistors (FETs)

(M1-M6) coupled as depicted. In this arrangement, the source or drain (referred to herein as S/D, where S/D may refer to either a source or a drain) of a FET is coupled to a gate of another FET. As just one example, the drain of M4 is connected to the gate of M2.

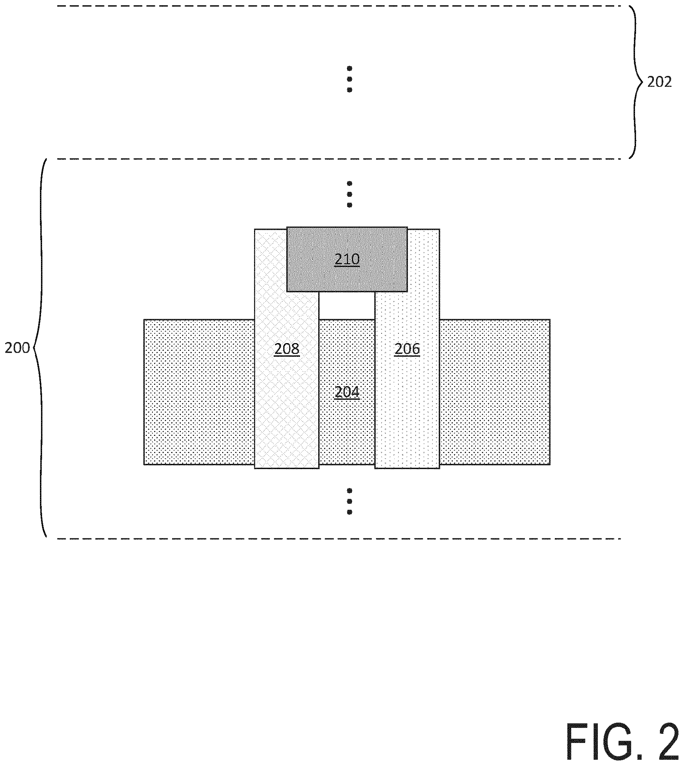

FIG. 2 is a side view of an example S/D to gate connection 210, in accordance with any of the embodiments disclosed herein. FIG. 2 depicts one or more device layers 200 (sometimes referred to as a front-end-of-line region) and one or more interconnect layers 202 (sometimes referred to as a back-end-of-line region). The device layer(s) 200 comprise a plurality of FETs with respective components (e.g., gates, drains, sources, channels, etc.). The interconnect layers 202 comprise a plurality of interconnect layers that may couple devices of the device layer(s) 200 together.

In some integrated circuit devices, the connections between S/Ds of certain transistors and gates of other transistors (e.g., as required in an SRAM cell) may be accomplished using a metal layer of the interconnect layers 202 (e.g., a metal 0 layer that is closest to the device layer(s) 200. However, in various embodiments of the present disclosure, at least some of the S/D to gate connections (e.g., 210) are formed in the device layer(s) 200, e.g., these S/D to gate connections may be formed directly on the gate and S/D materials.

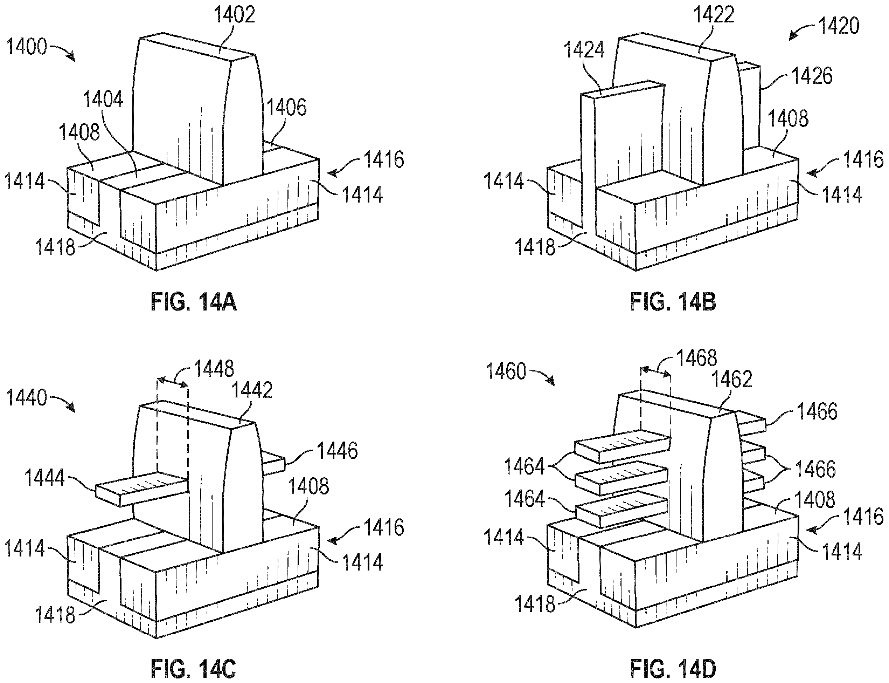

In various embodiments, (such as the embodiment depicted), gate-all-around transistors (e.g., such as those depicted in FIGs. 14A-D) may comprise a first transistor with a gate 206 formed around a channel 204 and a second transistor with a S/D 208 formed around the channel 204. The gate 206 of the first transistor is coupled to the S/D 208 of the second transistor through a S/D to gate connection 210 within the device layer(s) 200.

Although not shown, in various embodiments, the S/D to gate connection 210 may couple an S/D of an additional transistor to the gate 206. For example, a third transistor may be formed above the second transistor in the device layer(s) in a stacked transistor topography and an S/D of the third transistor may be coupled to the gate 206 of the first transistor through the same S/D to gate connection 210.

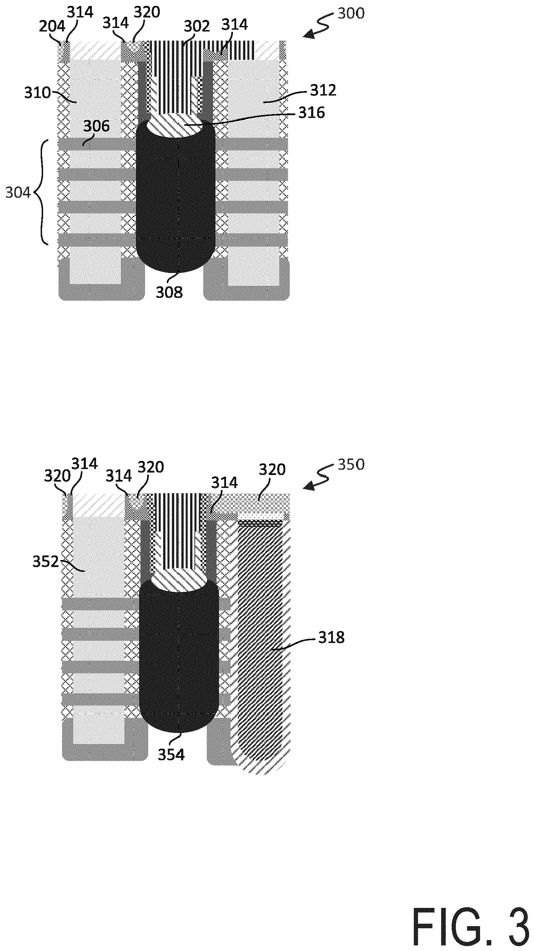

FIG. 3 is a cross section of a portion of an SRAM cell 300 comprising an S/D to gate connection 302 and a cross section of other logic 350 integrated with the SRAM cell 300, in accordance with any of the embodiments disclosed herein. In FIG. 3, as well as in successive figures, the cross section is taken through a portion of a gate of a first transistor (e.g., it is a gate cut cross section). In the embodiment depicted, the SRAM cell 300 comprises a channel 304 comprising a plurality of nanoribbons 306 which extend, e.g., along a direction of a fin. The SRAM cell 300 cell also includes a gate material 310 (e.g., gate metal) of a first transistor and a gate material 312 of a second transistor.

The S/D to gate connection 302 couples the S/D material 308 (e.g., doped epitaxial silicon or other suitable material) of the first transistor to the gate material 312 of the second transistor. The SRAM cell 300 also includes a low-k dielectric 314. In various embodiments, the low-k dielectric 314 may be buried underneath a portion of the S/D to gate connection 302. During fabrication, the low-k dielectric 314 acts as an etch stop layer, protecting one or more material layers underneath the low-k dielectric from an etching process, so as not to expose ohmic contact material 316 (e.g., a silicide, such as titanium silicide) or the S/D material 308 to unwanted removal which could cause formation of an open circuit between the S/D material 308 of the first transistor and the S/D to gate connection 302 and thus also an open circuit between the S/D material 308 and the gate material 312 of the second transistor.

At least a portion of the low-k dielectric 314 may be formed over an area between gate material 312 and the S/D material 308. Because the low-k dielectric 314 may be formed in a film, the low-k dielectric 314 may be present in other portions of the SRAM cell 300, such as over an area between the S/D material 308 and the other gate material 310.

The low-k dielectric 314 may also be present in other portions (not shown) of the SRAM cell 300 as well in other logic 350 that is cointegrated (e.g., in the same plane) as the SRAM cell 300. For example, the low-k dielectric 314 may be present above an area between S/D material 354 and gate material 352 or above an area between S/D material 354 and an isolation dielectric 318. Because this low-k dielectric 314 may replace volume that would otherwise be occupied by a higher-k dielectric, a reduction in parasitic capacitance in transistors of the other logic 350 may also be achieved in some embodiments.

During fabrication, the low-k dielectric 314 may be capped with a nitride cap material 320 to protect it from one or more subsequent operations. A large portion of this nitride cap material 320 may be removed during fabrication, but portions of it may persist (e.g., some of the nitride cap material 320 may be present within small recesses formed in the low-k dielectric 314) or above the isolation dielectric 318.

In various embodiments, the low-k dielectric 314 may comprise silicon, oxygen, and carbon. In some embodiments, the low-k dielectric 314 comprises silicon oxide doped with carbon. In various embodiments, the low-k dielectric comprises silicon and has one or more of the following constraints on atomic percentage: nitrogen < 20%, oxygen > 20%, and carbon > 5%. Any or all of these composition ranges may result in a low-k dielectric 314 that is less like silicon nitride and more like silicon oxide, thus having a lower etch rate and lower k value than pure silicon nitride.

In various embodiments, the low-k dielectric 314 may have a high etch selectivity to silicon nitride, that is, the etch rate of the low-k dielectric 314 may be relatively low compared to the etch rate of silicon nitride, thus the low-k dielectric 314 may be used as an etch stop during an etch in which other materials comprising a relatively large amount of silicon nitride may be wholly or partially removed.

In various embodiments, the low-k dielectric 314 may have a dielectric constant (k) value that is higher than silicon oxide, but lower than silicon nitride. In some embodiments, the low-k dielectric 314 may have a k value of between 3.8 to 5 (although embodiments aren't limited thereto) as this may result from a composition of the low-k dielectric 314 that makes it suitable to protect lower layers through its etch selectivity.

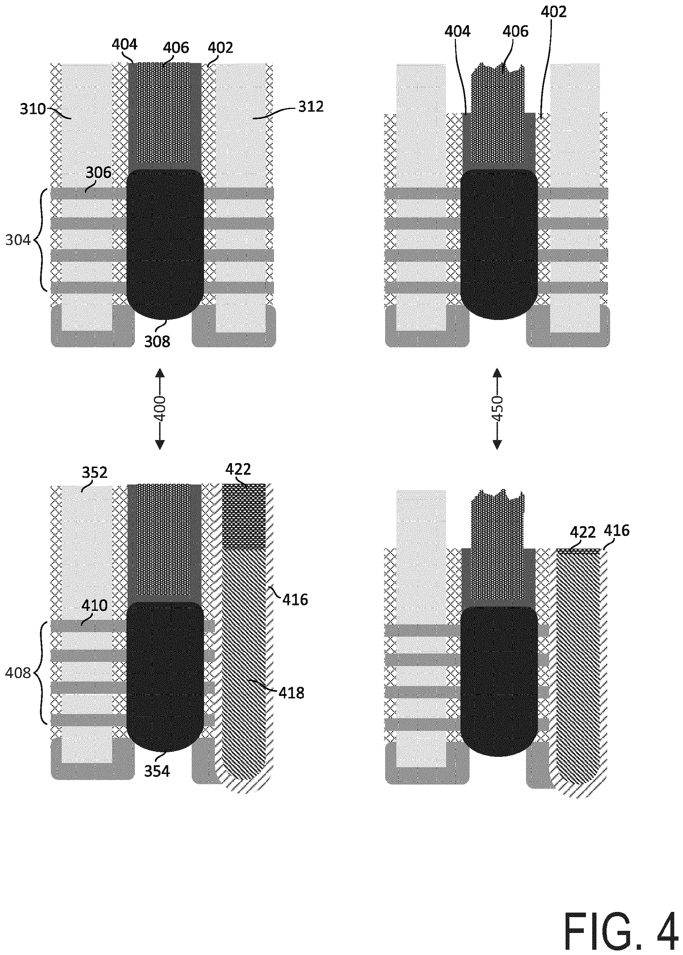

Example phases of manufacture are now described for the portion of the SRAM cell 300 and the logic 350 in FIGs. 4-11. In each of these FIGs., the top two figures represent phases of manufacture of the SRAM cell 300 and the bottom two figures represent the same phases of manufacture of the logic 350.

Phase 400 of FIG. 4 depicts SRAM cell 300 (top) and logic 350 (bottom) after a polishing operation has been performed on the gate material (e.g., 310, 312, 352) (e.g., tungsten). At this phase, the SRAM cell 300 comprises channel 304, gate materials 310 and 312, and S/D material 308. The gate materials are separated from the S/D material 308 by a nitride-like spacer material 402, such as silicon nitride with oxygen and/or carbon doping (e.g., SiOCN, SiCN) (which at least in some embodiments may have a higher k value and higher etch rate than the low-k dielectric 314). A nitride liner 404 (e.g., comprising silicon nitride) is formed in a trench configuration above the S/D material 308 and is filled with a trench contact oxide 406 (e.g., silicon oxide). In some embodiments, the nitride-like spacer material 402 may have a lower k value than the nitride liner 404. In various embodiments, the nitride liner 404 may have a higher k value and higher etch rate than the low-k dielectric 314.

Logic 350 comprises (among other portions such as 402, 404, 406 that may be similar to those in SRAM cell 300) a channel 408 comprising nanoribbons 410, S/D material 354, and gate material 352. However, in the logic 350, an additional instance of the gate material has been removed and replaced with an insulator. Thus, in place of an additional gate material, the logic 350 includes a nitride liner 416 (e.g., comprising silicon nitride) filled with an isolation dielectric 418 (e.g., silicon oxide) and a nitride plug 422 (e.g., comprising silicon nitride) on top of the isolation dielectric 418. Such a technique may be used, for instance, in fin trim isolation (FTI) fabrication.

Phase 450 depicts SRAM cell 300 and logic 350 after a nitride recessing operation has been performed. This operation may include the removal (e.g., by etching) of nitride based materials. For example, as depicted, this operation may remove portions of the nitride-like spacer material 402 and nitride liner 404. This operation may also cause some damage to the top of the trench contact oxide 406 (the damage will be removed in a future polishing operation). For the logic 350, this operation also removes some of the nitride liner 416 and a large portion of the nitride plug 422.

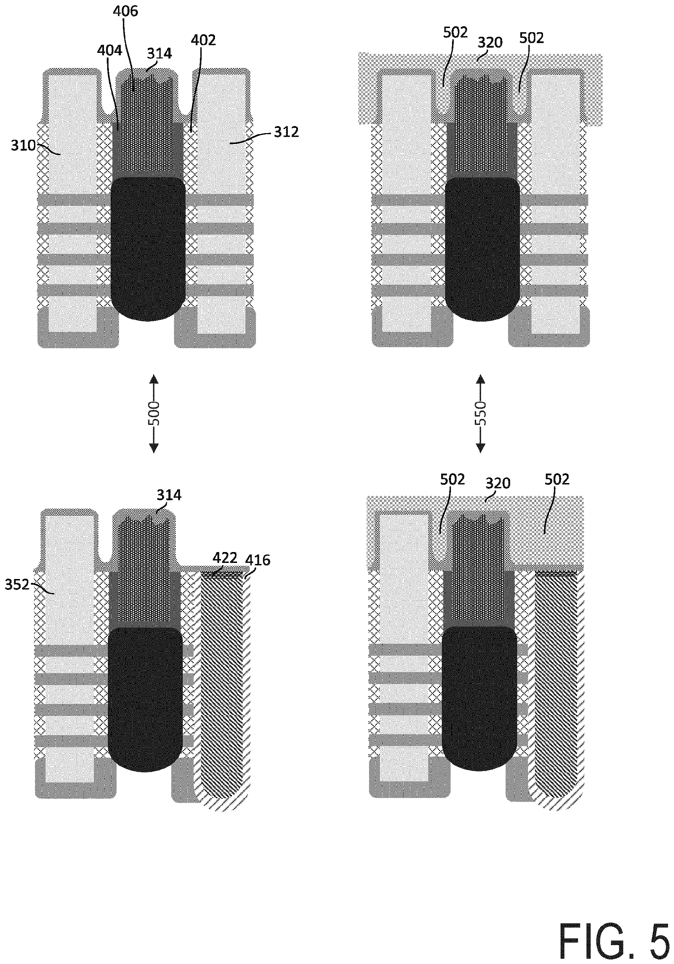

Phase 500 of FIG. 5 depicts SRAM cell 300 and logic 350 after a low-k dielectric 314 with high etch selectivity to SiN has been deposited. In the embodiment depicted, the low-k dielectric 314 is deposited on the gate materials 310 and 312, the nitride-like spacer material 402, the nitride liner 404, the trench contact oxide 406 (and the nitride liner 416 and nitride plug 422 in the case of the logic 350). The low-k dielectric 314 may be formed using various deposition techniques, such as Chemical Vapor Deposition (CVD), Physical Vapor Deposition (PVD), or Atomic Layer Deposition (ALD).

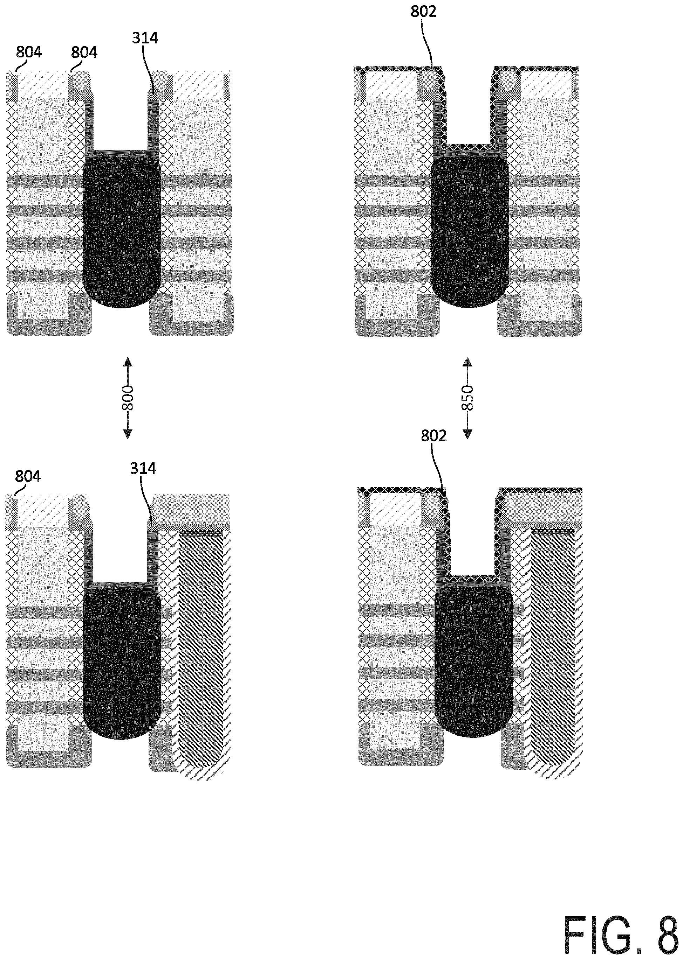

Phase 550 of FIG. 5 depicts SRAM cell 300 and logic 350 after a nitride cap material 320 has been deposited on the low-k dielectric 314. In various embodiments, the nitride cap material 320 may comprise silicon nitride or other suitable material (e.g., that has selectivity to low-k or oxide related etch). This nitride cap material 320 helps restore nitride in the areas that were removed during the nitride recessing operation shown in phase 450 (e.g., to maintain a nitride based spacing material between the gate materials and the S/D material). The nitride cap material 320 may also protect the low-k dielectric 314 from a subsequent operation (e.g., shown in phase 800 of FIG. 8) that removes the trench contact oxide 406. As depicted, the nitride cap material 320 may fill in recesses 502 in the low-k dielectric 314.

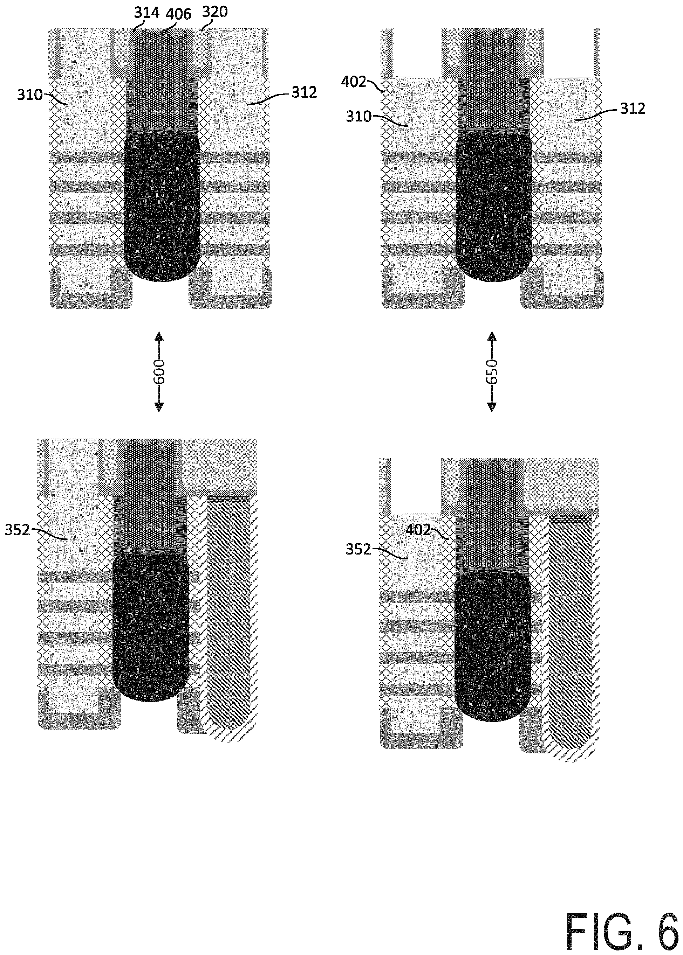

Phase 600 of FIG. 6 depicts SRAM cell 300 and logic 350 after another polishing operation has been performed. For both the SRAM cell 300 and logic 350, this polishing removes portions of nitride cap material 320 and low-k dielectric 314 (and potentially small portions of the trench contact oxide 406 that extend above the level of the top of the gate materials 310 and 312). This polishing operation may stop at the top of the gate materials (thus exposing the gate materials).

Phase 650 of FIG. 6 depicts SRAM cell 300 and logic 350 after a gate recessing operation is performed. In this operation, portions of the gate materials 310, 312, 352 may be removed (e.g., via an etch process). In various embodiments, the gate materials may be removed down to (or substantially near) the top of the nitride-like spacer material 402.

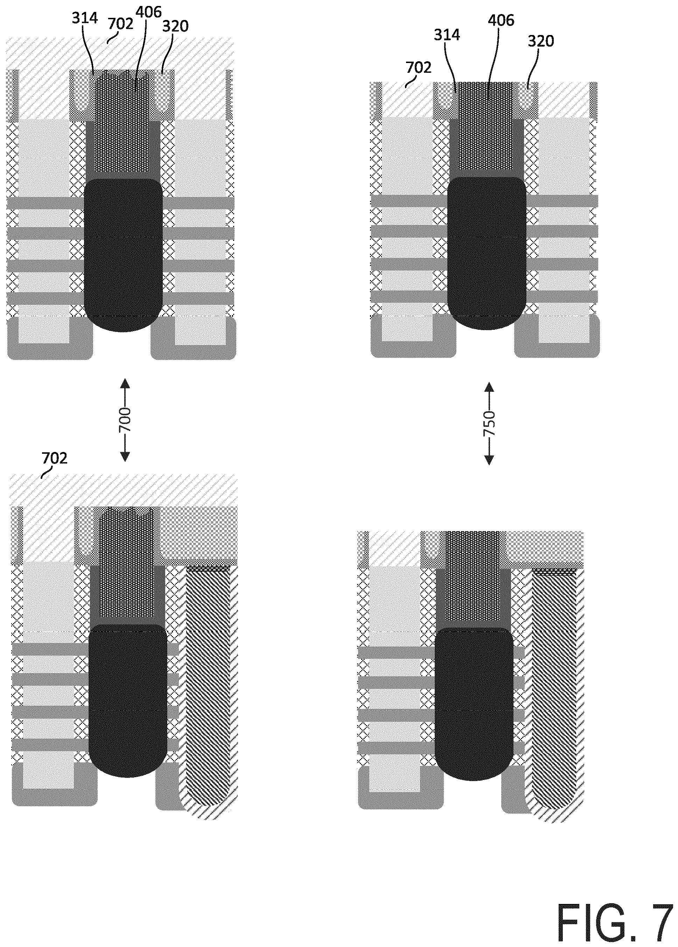

Phase 700 of FIG. 7 depicts SRAM cell 300 and logic 350 after deposition of a nitride fill 702. The nitride fill 702 may be deposited in the area previously occupied by the portions of the gate materials removed in the gate recess operation as well as on top of the low-k dielectric 314 and nitride cap material 320. The nitride fill 702 may be a similar material to the nitride cap material 320, but is not necessarily the same material in various embodiments.

Phase 750 of FIG. 7 depicts SRAM cell 300 and logic 350 after another polishing operation is performed. In this operation, portions of the nitride fill 702, nitride cap material 320, low-k dielectric 314, and trench contact oxide 406 are removed. In this operation, the damage to the trench contact oxide 406 is removed.

Phase 800 of FIG. 8 depicts SRAM cell 300 and logic 350 after a recess operation is performed on the trench contact oxide 406. This operation removes the trench contact oxide 406 above the S/D material 308 and S/D material 354 and opens up a trench above the respective S/D materials. In this operation, the low-k dielectric 314 may be slightly eroded (e.g., due to imperfect selectivity to the oxide recess chemistry) and may create small recesses 804 in the low-k material 314 as shown.

Phase 850 of FIG. 8 depicts SRAM cell 300 and logic 350 after a nitride liner 802 (e.g., comprising silicon nitride) is deposited. The nitride liner 802 may fill in the small recesses 804 in the low-k material 314 created at phase 800 and will line the trench over the S/D material 308, 354.

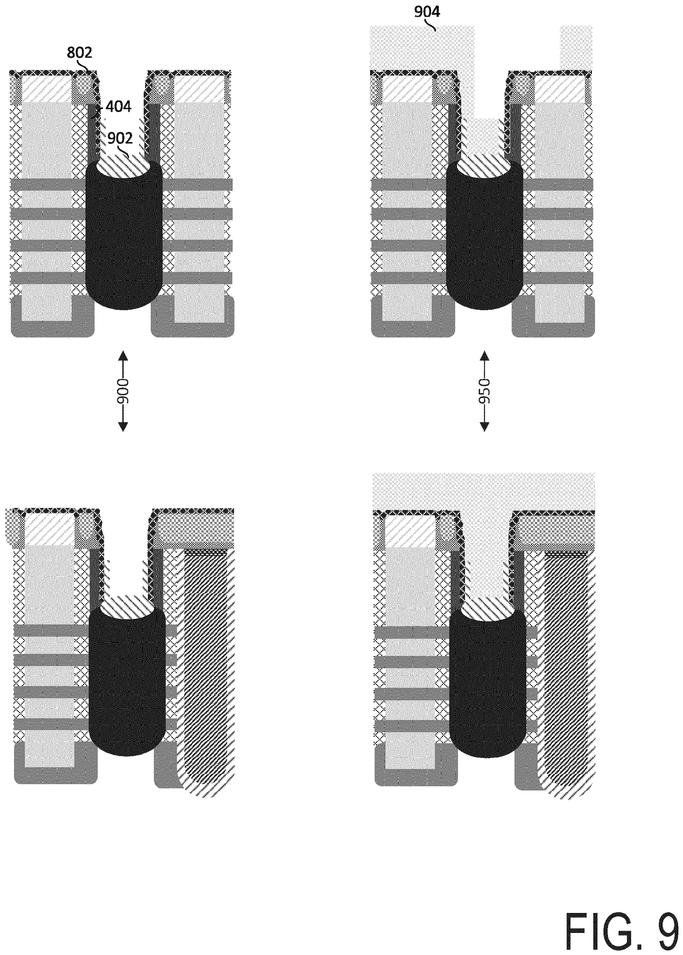

Phase 900 of FIG. 9 depicts SRAM cell 300 and logic 350 after etching of the nitride liners 404 and 802 and formation of an ohmic contact material 316 above the S/D materials. The ohmic contact material may comprise, e.g., TiSi. In various embodiments, the ohmic contact material 316 may improve the connection between the eventual electrode material (e.g., tungsten) and the S/D material.

Phase 950 of FIG. 9 depicts SRAM cell 300 and logic 350 after patterning for the S/D to gate connection. This patterning may involve, e.g., deposition and etching of a lithography material, such as carbon hard mask 904. The logic 350 is simply covered by the carbon hard mask in this phase. This operation leaves a void for formation of the S/D to gate connection.

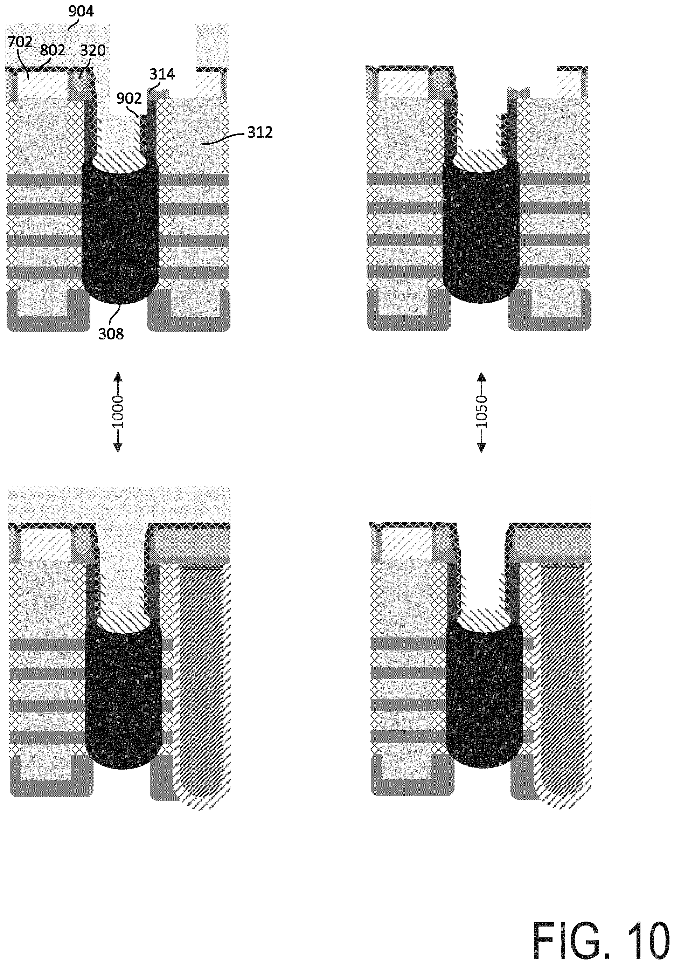

Phase 1000 of FIG. 10 depicts SRAM cell 300 and logic 350 after a nitride etch is performed. The nitride etch may fully remove nitride cap material 320, nitride fill 702, and nitride liner 802 that is not covered by the carbon hard mask 904, thus exposing the gate material 312 for connection to the S/D material 308 (e.g., by forming a trench above the gate material 312). However, the low-k dielectric protects underlying material from being etched away during this operation, and thus the etch material does not reach the S/D material 308 or ohmic contact material 316 (thus keeping the S/D and ohmic contact material 316 protected from subsequent cleaning operations, such as wet etches, that could otherwise remove portions thereof and create unwanted open circuits).

Phase 1050 of FIG. 10 depicts SRAM cell 300 and logic 350 after the carbon hard mask 904 is removed (e.g., via etching).

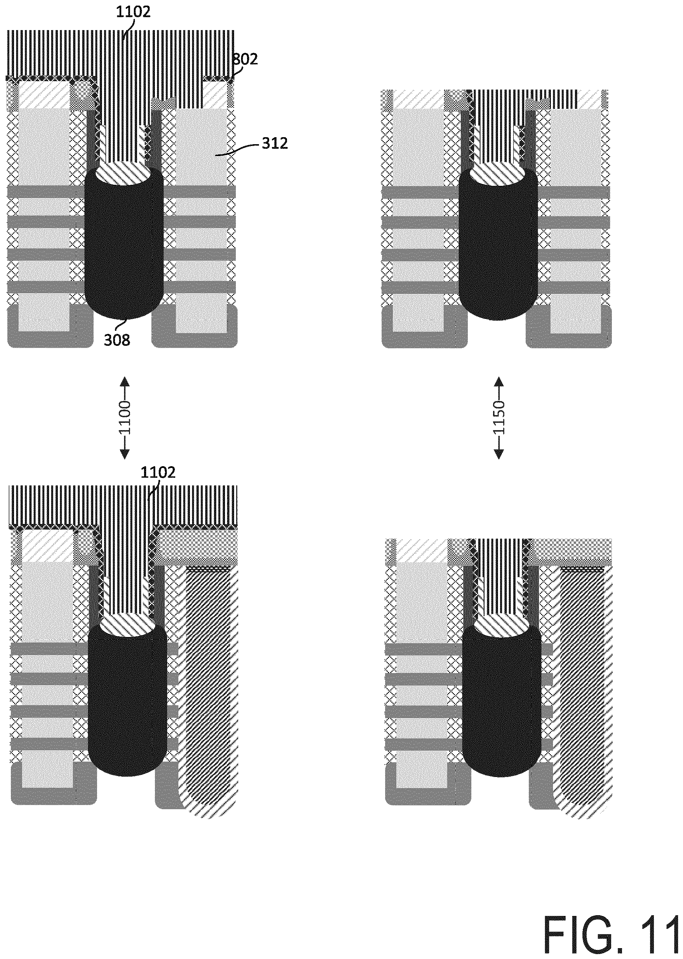

Phase 1100 of FIG. 11 depicts SRAM cell 300 and logic 350 after a conductive material 1102 (e.g., a metal, such as tungsten) is deposited. The conductive material forms a connection between the S/D material 308 and the gate material 312 and may form a common electrode for the gate of one transistor and the S/D of another transistor. The conductive material 1102 also forms an electrode for the S/D of the other logic 350.

Phase 1150 of FIG. 11 depicts SRAM cell 300 and logic 350 after a polishing operation has been performed on the conductive material 1102. In this operation, portions of the conductive material 1102 and the nitride liner 802 are removed. Damage from previous process operations (e.g., the small recesses in the low-k dielectric 314) may also be removed in this phase.

Although various embodiments herein describe a low-k dielectric 314 and nitride cap material 320 used during fabrication of an SRAM cell, the teachings herein may be applied to any suitable S/D to gate connection for transistors of any suitable circuits or to other locations within an integrated circuit device (e.g., to reduce parasitic capacitances of devices). Moreover, the techniques may be used with either or both of N type transistors or P type transistors.

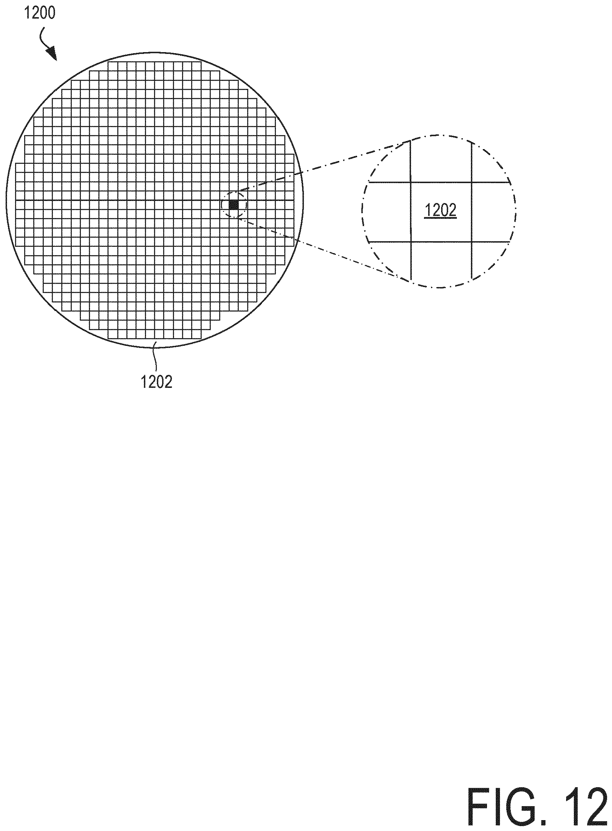

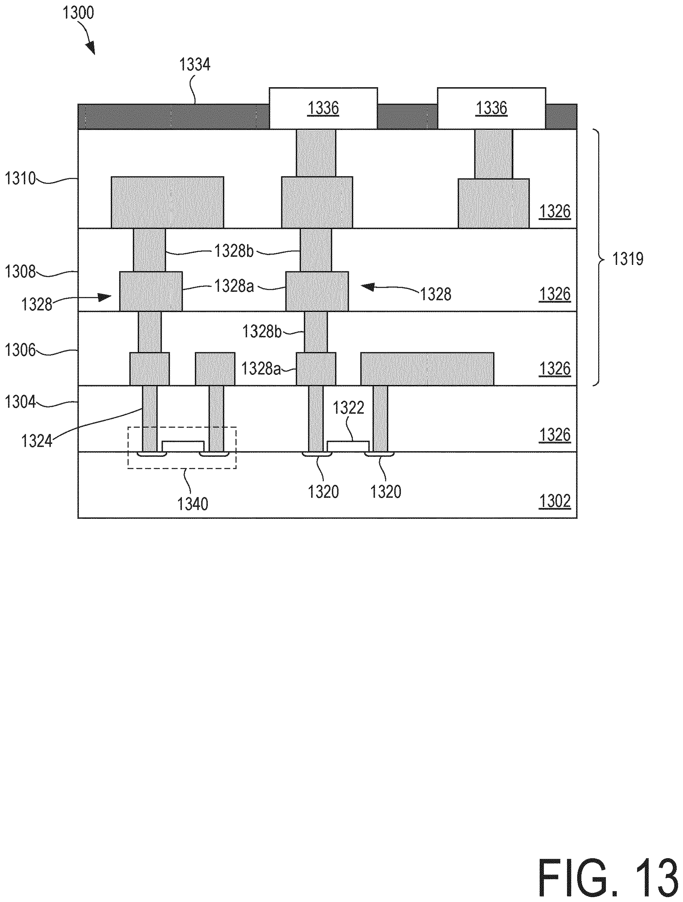

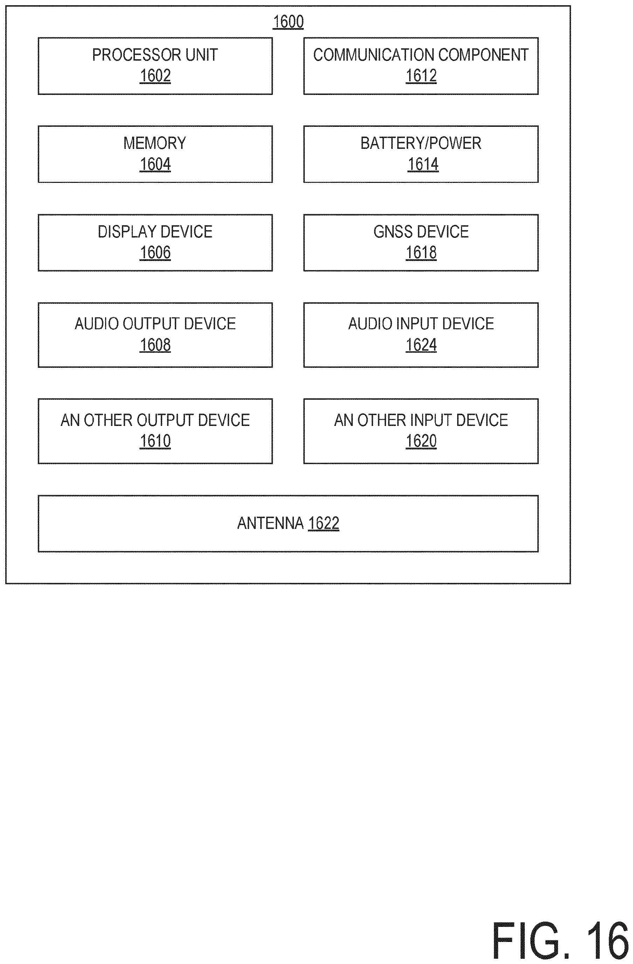

FIG. 12 is a top view of a wafer 1200 and dies 1202 that may include any of the embodiments described herein. The wafer 1200 may be composed of semiconductor material and may include one or more dies 1202 having integrated circuit structures formed on a surface of the wafer 1200. The individual dies 1202 may be a repeating unit of an integrated circuit product that includes any suitable integrated circuit. After the fabrication of the semiconductor product is complete, the wafer 1200 may undergo a singulation process in which the dies 1202 are separated from one another to provide discrete "chips" of the integrated circuit product. The die 1202 may include a buried low-k dielectric as disclosed herein. The die 1202 may include one or more transistors (e.g., some of the transistors 1340 of FIG. 13, discussed below), supporting circuitry to route electrical signals to the transistors, passive components (e.g., signal traces, resistors, capacitors, or inductors), and/or any other integrated circuit components. In some embodiments, the wafer 1200 or the die 1202 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1202. For example, a memory array formed by multiple memory devices may be formed on a same die 1202 as a processor unit (e.g., the processor unit 1602 of FIG. 16) or other logic that is configured to store information in the memory devices or execute instructions stored in the memory array. Various ones of the microelectronic assemblies disclosed herein may be manufactured using a die-to-wafer assembly technique in which some dies are attached to a wafer 1200 that include others of the dies, and the wafer 1200 is subsequently singulated.

FIG. 13 is a cross-sectional side view of an integrated circuit device 1300 that may include a buried low-k dielectric disclosed herein. One or more of the integrated circuit devices 1300 may be included in one or more dies 1202 (FIG. 12). The integrated circuit device 1300 may be formed on a die substrate 1302 (e.g., the wafer 1200 of FIG. 12) and may be included in a die (e.g., the die 1202 of FIG. 12). The die substrate 1302 may be a semiconductor substrate composed of semiconductor material systems including, for example, n-type or p-type materials systems (or a combination of both). The die substrate 1302 may include, for example, a crystalline substrate formed using a bulk silicon or a silicon-on-insulator (SOI) substructure. In some embodiments, the die substrate 1302 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1302. Although a few examples of materials from which the die substrate 1302 may be formed are described here, any material that may serve as a foundation for an integrated circuit device 1300 may be used. The die substrate 1302 may be part of a singulated die (e.g., the dies 1202 of FIG. 12) or a wafer (e.g., the wafer 1200 of FIG. 12).

The integrated circuit device 1300 may include one or more device layers 1304 disposed on the die substrate 1302. The device layer 1304 may include features of one or more transistors 1340 (e.g., metal oxide semiconductor field-effect transistors (MOSFETs)) formed on the die substrate 1302. The transistors 1340 may include, for example, one or more source and/or drain (S/D) regions 1320, a gate 1322 to control current flow between the S/D regions 1320, and one or more S/D contacts 1324 to route electrical signals to/from the S/D regions 1320. The transistors 1340 may include additional features not depicted for the sake of clarity, such as device isolation regions, gate contacts, and the like. The transistors 1340 are not limited to the type and configuration depicted in FIG. 13 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

FIGS. 14A-14D are simplified perspective views of example planar, FinFET, gate-all-around, and stacked gate-all-around transistors. The transistors illustrated in FIGS. 14A-14D are formed on a substrate 1416 having a surface 1408. Isolation regions 1414 separate the source and drain regions of the transistors from other transistors and from a bulk region 1418 of the substrate 1416.

FIG. 14A is a perspective view of an example planar transistor 1400 comprising a gate 1402 that controls current flow between a source region 1404 and a drain region 1406. The transistor 1400 is planar in that the source region 1404 and the drain region 1406 are planar with respect to the substrate surface 1408.

FIG. 14B is a perspective view of an example FinFET transistor 1420 comprising a gate 1422 that controls current flow between a source region 1424 and a drain region 1426. The transistor 1420 is non-planar in that the source region 1424 and the drain region 1426 comprise "fins" that extend upwards from the substrate surface 1428. As the gate 1422 encompasses three sides of the semiconductor fin that extends from the source region 1424 to the drain region 1426, the transistor 1420 can be considered a tri-gate transistor. FIG. 14B illustrates one S/D fin extending through the gate 1422, but multiple S/D fins can extend through the gate of a FinFET transistor.

FIG. 14C is a perspective view of a gate-all-around (GAA) transistor 1440 comprising a gate 1442 that controls current flow between a source region 1444 and a drain region 1446. The transistor 1440 is non-planar in that the source region 1444 and the drain region 1446 are elevated from the substrate surface 1428.

FIG. 14D is a perspective view of a GAA transistor 1460 comprising a gate 1462 that controls current flow between multiple elevated source regions 1464 and multiple elevated drain regions 1466. The transistor 1460 is a stacked GAA transistor as the gate controls the flow of current between multiple elevated S/D regions stacked on top of each other. The transistors 1440 and 1460 are considered gate-all-around transistors as the gates encompass all sides of the semiconductor portions that extends from the source regions to the drain regions. The transistors 1440 and 1460 can alternatively be referred to as nanowire, nanosheet, or nanoribbon transistors depending on the width (e.g., widths 1448 and 1468 of transistors 1440 and 1460, respectively) of the semiconductor portions extending through the gate.

Returning to FIG. 13, a transistor 1340 may include a gate 1322 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1340 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1340 along the source-channel-drain direction, the gate electrode may consist of a U-shaped structure that includes a bottom portion substantially parallel to the surface of the die substrate 1302 and two sidewall portions that are substantially perpendicular to the top surface of the die substrate 1302. In other embodiments, at least one of the metal layers that form the gate electrode may simply be a planar layer that is substantially parallel to the top surface of the die substrate 1302 and does not include sidewall portions substantially perpendicular to the top surface of the die substrate 1302. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1320 may be formed within the die substrate 1302 adjacent to the gate 1322 of individual transistors 1340. The S/D regions 1320 may be formed using an implantation/diffusion process or an etching/deposition process, for example. In the former process, dopants such as boron, aluminum, antimony, phosphorous, or arsenic may be ion-implanted into the die substrate 1302 to form the S/D regions 1320. An annealing process that activates the dopants and causes them to diffuse farther into the die substrate 1302 may follow the ion-implantation process. In the latter process, the die substrate 1302 may first be etched to form recesses at the locations of the S/D regions 1320. An epitaxial deposition process may then be carried out to fill the recesses with material that is used to fabricate the S/D regions 1320. In some implementations, the S/D regions 1320 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1320 may be formed using one or more alternate semiconductor materials such as germanium or a group III-V material or alloy. In further embodiments, one or more layers of metal and/or metal alloys may be used to form the S/D regions 1320.

Electrical signals, such as power and/or input/output (I/O) signals, may be routed to and/or from the devices (e.g., transistors 1340) of the device layer 1304 through one or more interconnect layers disposed on the device layer 1304 (illustrated in FIG. 13 as interconnect layers 1306-1310). For example, electrically conductive features of the device layer 1304 (e.g., the gate 1322 and the S/D contacts 1324) may be electrically coupled with the interconnect structures 1328 of the interconnect layers 1306-1310. The one or more interconnect layers 1306-1310 may form a metallization stack (also referred to as an "ILD stack") 1319 of the integrated circuit device 1300.

The interconnect structures 1328 may be arranged within the interconnect layers 1306-1310 to route electrical signals according to a wide variety of designs; in particular, the arrangement is not limited to the particular configuration of interconnect structures 1328 depicted in FIG. 13. Although a particular number of interconnect layers 1306-1310 is depicted in FIG. 13, embodiments of the present disclosure include integrated circuit devices having more or fewer interconnect layers than depicted.

In some embodiments, the interconnect structures 1328 may include lines 1328a and/or vias 1328b filled with an electrically conductive material such as a metal. The lines 1328a may be arranged to route electrical signals in a direction of a plane that is substantially parallel with a surface of the die substrate 1302 upon which the device layer 1304 is formed. For example, the lines 1328a may route electrical signals in a direction in and out of the page and/or in a direction across the page. The vias 1328b may be arranged to route electrical signals in a direction of a plane that is substantially perpendicular to the surface of the die substrate 1302 upon which the device layer 1304 is formed. In some embodiments, the vias 1328b may electrically couple lines 1328a of different interconnect layers 1306-1310 together.

The interconnect layers 1306-1310 may include a dielectric material 1326 disposed between the interconnect structures 1328, as shown in FIG. 13. In some embodiments, dielectric material 1326 disposed between the interconnect structures 1328 in different ones of the interconnect layers 1306-1310 may have different compositions; in other embodiments, the composition of the dielectric material 1326 between different interconnect layers 1306-1310 may be the same. The device layer 1304 may include a dielectric material 1326 disposed between the transistors 1340 and a bottom layer of the metallization stack as well. The dielectric material 1326 included in the device layer 1304 may have a different composition than the dielectric material 1326 included in the interconnect layers 1306-1310; in other embodiments, the composition of the dielectric material 1326 in the device layer 1304 may be the same as a dielectric material 1326 included in any one of the interconnect layers 1306-1310.

A first interconnect layer 1306 (referred to as Metal 1 or "M1") may be formed directly on the device layer 1304. In some embodiments, the first interconnect layer 1306 may include lines 1328a and/or vias 1328b, as shown. The lines 1328a of the first interconnect layer 1306 may be coupled with contacts (e.g., the S/D contacts 1324) of the device layer 1304. The vias 1328b of the first interconnect layer 1306 may be coupled with the lines 1328a of a second interconnect layer 1308.

The second interconnect layer 1308 (referred to as Metal 2 or "M2") may be formed directly on the first interconnect layer 1306. In some embodiments, the second interconnect layer 1308 may include via 1328b to couple the lines 1328 of the second interconnect layer 1308 with the lines 1328a of a third interconnect layer 1310. Although the lines 1328a and the vias 1328b are structurally delineated with a line within individual interconnect layers for the sake of clarity, the lines 1328a and the vias 1328b may be structurally and/or materially contiguous (e.g., simultaneously filled during a dual-damascene process) in some embodiments.

The third interconnect layer 1310 (referred to as Metal 3 or "M3") (and additional interconnect layers, as desired) may be formed in succession on the second interconnect layer 1308 according to similar techniques and configurations described in connection with the second interconnect layer 1308 or the first interconnect layer 1306. In some embodiments, the interconnect layers that are "higher up" in the metallization stack 1319 in the integrated circuit device 1300 (i.e., farther away from the device layer 1304) may be thicker that the interconnect layers that are lower in the metallization stack 1319, with lines 1328a and vias 1328b in the higher interconnect layers being thicker than those in the lower interconnect layers.

The integrated circuit device 1300 may include a solder resist material 1334 (e.g., polyimide or similar material) and one or more conductive contacts 1336 formed on the interconnect layers 1306-1310. In FIG. 13, the conductive contacts 1336 are illustrated as taking the form of bond pads. The conductive contacts 1336 may be electrically coupled with the interconnect structures 1328 and configured to route the electrical signals of the transistor(s) 1340 to external devices. For example, solder bonds may be formed on the one or more conductive contacts 1336 to mechanically and/or electrically couple an integrated circuit die including the integrated circuit device 1300 with another component (e.g., a printed circuit board). The integrated circuit device 1300 may include additional or alternate structures to route the electrical signals from the interconnect layers 1306-1310; for example, the conductive contacts 1336 may include other analogous features (e.g., posts) that route the electrical signals to external components.

In some embodiments in which the integrated circuit device 1300 is a double-sided die, the integrated circuit device 1300 may include another metallization stack (not shown) on the opposite side of the device layer(s) 1304. This metallization stack may include multiple interconnect layers as discussed above with reference to the interconnect layers 1306-1310, to provide conductive pathways (e.g., including conductive lines and vias) between the device layer(s) 1304 and additional conductive contacts (not shown) on the opposite side of the integrated circuit device 1300 from the conductive contacts 1336.

In other embodiments in which the integrated circuit device 1300 is a double-sided die, the integrated circuit device 1300 may include one or more through silicon vias (TSVs) through the die substrate 1302; these TSVs may make contact with the device layer(s) 1304, and may provide conductive pathways between the device layer(s) 1304 and additional conductive contacts (not shown) on the opposite side of the integrated circuit device 1300 from the conductive contacts 1336. In some embodiments, TSVs extending through the substrate can be used for routing power and ground signals from conductive contacts on the opposite side of the integrated circuit device 1300 from the conductive contacts 1336 to the transistors 1340 and any other components integrated into the circuit device (e.g., die) 1300, and the metallization stack 1319 can be used to route I/O signals from the conductive contacts 1336 to transistors 1340 and any other components integrated into the circuit device (e.g., die) 1300.

Multiple integrated circuit devices 1300 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

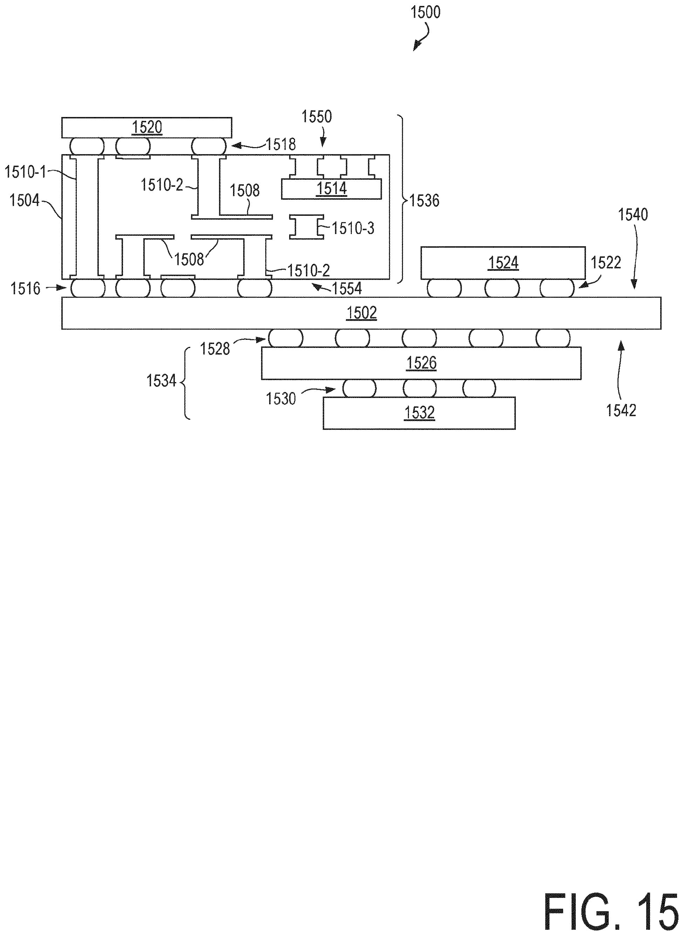

FIG. 15 is a cross-sectional side view of an integrated circuit device assembly 1500 that may include any of the embodiments disclosed herein. The integrated circuit device assembly 1500 includes a number of components disposed on a circuit board 1502 (which may be a motherboard, system board, mainboard, etc.). The integrated circuit device assembly 1500 includes components disposed on a first face 1540 of the circuit board 1502 and an opposing second face 1542 of the circuit board 1502; generally, components may be disposed on one or both faces 1540 and 1542.

In some embodiments, the circuit board 1502 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1502. In other embodiments, the circuit board 1502 may be a non-PCB substrate. The integrated circuit device assembly 1500 illustrated in FIG. 15 includes a package-on-interposer structure 1536 coupled to the first face 1540 of the circuit board 1502 by coupling components 1516. The coupling components 1516 may electrically and mechanically couple the package-on-interposer structure 1536 to the circuit board 1502, and may include solder balls (as shown in FIG. 15), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1536 may include an integrated circuit component 1520 coupled to an interposer 1504 by coupling components 1518. The coupling components 1518 may take any suitable form for the application, such as the forms discussed above with reference to the coupling components 1516. Although a single integrated circuit component 1520 is shown in FIG. 15, multiple integrated circuit components may be coupled to the interposer 1504; indeed, additional interposers may be coupled to the interposer 1504. The interposer 1504 may provide an intervening substrate used to bridge the circuit board 1502 and the integrated circuit component 1520.

The integrated circuit component 1520 may be a packaged or unpacked integrated circuit product that includes one or more integrated circuit dies (e.g., the die 1202 of FIG. 12, the integrated circuit device 1300 of FIG. 13) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1520, a single monolithic integrated circuit die comprises solder bumps attached to contacts on the die. The solder bumps allow the die to be directly attached to the interposer 1504. The integrated circuit component 1520 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1520 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1520 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1520 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1504 may spread connections to a wider pitch or reroute a connection to a different connection. For example, the interposer 1504 may couple the integrated circuit component 1520 to a set of ball grid array (BGA) conductive contacts of the coupling components 1516 for coupling to the circuit board 1502. In the embodiment illustrated in FIG. 15, the integrated circuit component 1520 and the circuit board 1502 are attached to opposing sides of the interposer 1504; in other embodiments, the integrated circuit component 1520 and the circuit board 1502 may be attached to a same side of the interposer 1504. In some embodiments, three or more components may be interconnected by way of the interposer 1504.

In some embodiments, the interposer 1504 may be formed as a PCB, including multiple metal layers separated from one another by layers of dielectric material and interconnected by electrically conductive vias. In some embodiments, the interposer 1504 may be formed of an epoxy resin, a fiberglass-reinforced epoxy resin, an epoxy resin with inorganic fillers, a ceramic material, or a polymer material such as polyimide. In some embodiments, the interposer 1504 may be formed of alternate rigid or flexible materials that may include the same materials described above for use in a semiconductor substrate, such as silicon, germanium, and other group III-V and group IV materials. The interposer 1504 may include metal interconnects 1508 and vias 1510, including but not limited to through hole vias 1510-1 (that extend from a first face 1550 of the interposer 1504 to a second face 1554 of the interposer 1504), blind vias 1510-2 (that extend from the first or second faces 1550 or 1554 of the interposer 1504 to an internal metal layer), and buried vias 1510-3 (that connect internal metal layers).

In some embodiments, the interposer 1504 can comprise a silicon interposer. Through silicon vias (TSV) extending through the silicon interposer can connect connections on a first face of a silicon interposer to an opposing second face of the silicon interposer. In some embodiments, an interposer 1504 comprising a silicon interposer can further comprise one or more routing layers to route connections on a first face of the interposer 1504 to an opposing second face of the interposer 1504.

The interposer 1504 may further include embedded devices 1514, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1504. The package-on-interposer structure 1536 may take the form of any of the package-on-interposer structures known in the art.

The integrated circuit device assembly 1500 may include an integrated circuit component 1524 coupled to the first face 1540 of the circuit board 1502 by coupling components 1522. The coupling components 1522 may take the form of any of the embodiments discussed above with reference to the coupling components 1516, and the integrated circuit component 1524 may take the form of any of the embodiments discussed above with reference to the integrated circuit component 1520.

The integrated circuit device assembly 1500 illustrated in FIG. 15 includes a package-on-package structure 1534 coupled to the second face 1542 of the circuit board 1502 by coupling components 1528. The package-on-package structure 1534 may include an integrated circuit component 1526 and an integrated circuit component 1532 coupled together by coupling components 1530 such that the integrated circuit component 1526 is disposed between the circuit board 1502 and the integrated circuit component 1532. The coupling components 1528 and 1530 may take the form of any of the embodiments of the coupling components 1516 discussed above, and the integrated circuit components 1526 and 1532 may take the form of any of the embodiments of the integrated circuit component 1520 discussed above. The package-on-package structure 1534 may be configured in accordance with any of the package-on-package structures known in the art.

FIG. 16 is a block diagram of an example electrical device 1600 that may include one or more of the embodiments disclosed herein. For example, any suitable ones of the components of the electrical device 1600 may include one or more of the integrated circuit device assemblies 1500, integrated circuit components 1520, integrated circuit devices 1300, or integrated circuit dies 1202 disclosed herein, and may be arranged in any of the microelectronic assemblies disclosed herein. A number of components are illustrated in FIG. 16 as included in the electrical device 1600, but any one or more of these components may be omitted or duplicated, as suitable for the application. In some embodiments, some or all of the components included in the electrical device 1600 may be attached to one or more motherboards mainboards, or system boards. In some embodiments, one or more of these components are fabricated onto a single system-on-a-chip (SoC) die.

Additionally, in various embodiments, the electrical device 1600 may not include one or more of the components illustrated in FIG. 16, but the electrical device 1600 may include interface circuitry for coupling to the one or more components. For example, the electrical device 1600 may not include a display device 1606, but may include display device interface circuitry (e.g., a connector and driver circuitry) to which a display device 1606 may be coupled. In another set of examples, the electrical device 1600 may not include an audio input device 1624 or an audio output device 1608, but may include audio input or output device interface circuitry (e.g., connectors and supporting circuitry) to which an audio input device 1624 or audio output device 1608 may be coupled.

The electrical device 1600 may include one or more processor units 1602 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1602 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1600 may include a memory 1604, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1604 may include memory that is located on the same integrated circuit die as the processor unit 1602. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1600 can comprise one or more processor units 1602 that are heterogeneous or asymmetric to another processor unit 1602 in the electrical device 1600. There can be a variety of differences between the processing units 1602 in a system in terms of a spectrum of metrics of merit including architectural, microarchitectural, thermal, power consumption characteristics, and the like. These differences can effectively manifest themselves as asymmetry and heterogeneity among the processor units 1602 in the electrical device 1600.

In some embodiments, the electrical device 1600 may include a communication component 1612 (e.g., one or more communication components). For example, the communication component 1612 can manage wireless communications for the transfer of data to and from the electrical device 1600. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1612 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1612 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1612 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1612 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1612 may operate in accordance with other wireless protocols in other embodiments. The electrical device 1600 may include an antenna 1622 to facilitate wireless communications and/or to receive other wireless communications (such as AM or FM radio transmissions).

In some embodiments, the communication component 1612 may manage wired communications, such as electrical, optical, or any other suitable communication protocols (e.g., IEEE 802.3 Ethernet standards). As noted above, the communication component 1612 may include multiple communication components. For instance, a first communication component 1612 may be dedicated to shorter-range wireless communications such as Wi-Fi or Bluetooth, and a second communication component 1612 may be dedicated to longer-range wireless communications such as global positioning system (GPS), EDGE, GPRS, CDMA, WiMAX, LTE, EV-DO, or others. In some embodiments, a first communication component 1612 may be dedicated to wireless communications, and a second communication component 1612 may be dedicated to wired communications.

The electrical device 1600 may include battery/power circuitry 1614. The battery/power circuitry 1614 may include one or more energy storage devices (e.g., batteries or capacitors) and/or circuitry for coupling components of the electrical device 1600 to an energy source separate from the electrical device 1600 (e.g., AC line power).

The electrical device 1600 may include a display device 1606 (or corresponding interface circuitry, as discussed above). The display device 1606 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1600 may include an audio output device 1608 (or corresponding interface circuitry, as discussed above). The audio output device 1608 may include any embedded or wired or wirelessly connected external device that generates an audible indicator, such speakers, headsets, or earbuds.

The electrical device 1600 may include an audio input device 1624 (or corresponding interface circuitry, as discussed above). The audio input device 1624 may include any embedded or wired or wirelessly connected device that generates a signal representative of a sound, such as microphones, microphone arrays, or digital instruments (e.g., instruments having a musical instrument digital interface (MIDI) output). The electrical device 1600 may include a Global Navigation Satellite System (GNSS) device 1618 (or corresponding interface circuitry, as discussed above), such as a Global Positioning System (GPS) device. The GNSS device 1618 may be in communication with a satellite-based system and may determine a geolocation of the electrical device 1600 based on information received from one or more GNSS satellites, as known in the art.

The electrical device 1600 may include another output device 1610 (or corresponding interface circuitry, as discussed above). Examples of the other output device 1610 may include an audio codec, a video codec, a printer, a wired or wireless transmitter for providing information to other devices, or an additional storage device.

The electrical device 1600 may include another input device 1620 (or corresponding interface circuitry, as discussed above). Examples of the other input device 1620 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1600 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1600 may be any other electronic device that processes data. In some embodiments, the electrical device 1600 may comprise multiple discrete physical components. Given the range of devices that the electrical device 1600 can be manifested as in various embodiments, in some embodiments, the electrical device 1600 can be referred to as a computing device or a computing system.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

Although an overview of embodiments has been described with reference to specific example embodiments, various modifications and changes may be made to these embodiments without departing from the broader scope of embodiments of the present disclosure.

The embodiments illustrated herein are described in sufficient detail to enable those skilled in the art to practice the teachings disclosed. Other embodiments may be used and derived therefrom, such that structural and logical substitutions and changes may be made without departing from the scope of this disclosure. The Detailed Description, therefore, is not to be taken in a limiting sense, and the scope of various embodiments is defined only by the appended claims, along with the full range of equivalents to which such claims are entitled.

It will also be understood that, although the terms "first," "second," and so forth may be used herein to describe various elements, these elements should not be limited by these terms. These terms are only used to distinguish one element from another. For example, a first contact could be termed a second contact, and, similarly, a second contact could be termed a first gate and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," "according to some embodiments," "in accordance with embodiments," or "in embodiments," which may each refer to one or more of the same or different embodiments. Furthermore, the terms "comprising," "including," "having," and the like, as used with respect to embodiments of the present disclosure, are synonymous.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn and Ni.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices. The term "signal" may refer to at least one current signal, voltage signal, magnetic signal, or data/clock signal.

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

Unless otherwise specified in the specific context of use, the term "predominantly" means more than 50%, or more than half. For example, a composition that is predominantly a first constituent means more than half of the composition (e.g., by volume) is the first constituent (e.g., >50 at. %). The term "primarily" means the most, or greatest, part. For example, a composition that is primarily a first constituent means the composition has more of the first constituent (e.g., by volume) than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

As used throughout this description, and in the claims, a list of items joined by the term "at least one of" or "one or more of" can mean any combination of the listed terms.

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.

Although the figures may illustrate embodiments where structures are substantially aligned to Cartesian axes (e.g., device structures having substantially vertical sidewalls), positive and negative (re-entrant) sloped feature sidewalls often occur in practice. For example, manufacturing non-idealities may cause one or more structural features to have sloped sidewalls. Thus, attributes illustrated are idealized merely for the sake of clearly describing salient features. It is to be understood that schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

The following examples are non-limiting recitations of the subject matter contemplated herein.

Example 1 includes an apparatus comprising a source or drain of a field effect transistor (FET); a first dielectric between a portion of the source or drain and a FET gate, the first dielectric comprising silicon nitride; and a second dielectric above at least a portion of the first dielectric, the second dielectric comprising silicon oxide doped with at least one of oxygen or carbon, the second dielectric having a dielectric constant lower than the first dielectric.

Example 2 includes the subject matter of Example 1, and further including a third dielectric formed within a recess in the second dielectric, the third dielectric comprising silicon nitride.

Example 3 includes the subject matter of any of Examples 1 and 2, and wherein the second dielectric is below and in contact with a conductive material connecting the source or drain to the gate.

Example 4 includes the subject matter of any of Examples 1-3, and wherein the source or drain is a source or drain of a first FET of a static random access memory (SRAM) cell and the gate is a gate of a second FET of the SRAM cell.

Example 5 includes the subject matter of any of Examples 1-4, and wherein the source or drain is a source or drain of a transistor and the gate is a gate of the same transistor.

Example 6 includes the subject matter of any of Examples 1-5, and wherein the second dielectric has an atomic percentage of nitrogen that is less than 20%.

Example 7 includes the subject matter of any of Examples 1-6, and wherein the second dielectric has an atomic percentage of carbon that is greater than 5%.

Example 8 includes the subject matter of any of Examples 1-7, and wherein the second dielectric has an atomic percentage of oxygen that is greater than 20%.

Example 9 includes the subject matter of any of Examples 1-8, and further including a third dielectric in between and in contact with the source or drain and the second dielectric.

Example 10 includes the subject matter of any of Examples 1-9, and further including a nitride liner in contact with the source or drain and the third dielectric.

Example 11 includes the subject matter of any of Examples 1-10, and further including an integrated circuit die comprising the source or drain, the first dielectric, and the second dielectric.

Example 12 includes the subject matter of any of Examples 1-11, and further including a circuit board coupled to the integrated circuit die.

Example 13 includes the subject matter of any of Examples 1-12, further comprising at least one of a network interface, battery, or memory coupled to the integrated circuit die.

Example 14 includes an integrated circuit device comprising a first transistor comprising a source or drain; a second transistor comprising a gate; an electrically conductive connection between the source or drain of the first transistor and the gate of the second transistor; a first dielectric under and in contact with the electrically conductive connection; and a second dielectric under and in contact with the first dielectric.

Example 15 includes the subject matter of Example 14, and wherein the first dielectric comprises silicon oxide and has an atomic percentage of nitrogen that is less than 20%, an atomic percentage of carbon that is greater than 5%, and an atomic percentage of oxygen that is greater than 20%.

Example 16 includes the subject matter of any of Examples 14 and 15, and wherein the second dielectric comprises silicon nitride.

Example 17 includes the subject matter of any of Examples 14-16, and wherein the first dielectric has a dielectric constant that is lower than the second dielectric.

Example 18 includes the subject matter of any of Examples 14-17, and further including a third dielectric formed within a recess in the first dielectric, the third dielectric comprising silicon nitride.

Example 19 includes the subject matter of any of Examples 14-18, and wherein the source or drain is a source or drain of a first FET of a static random access memory (SRAM) cell and the gate is a gate of a second FET of the SRAM cell.

Example 20 includes the subject matter of any of Examples 14-19, and wherein the first dielectric has an atomic percentage of nitrogen that is less than 20%.

Example 21 includes the subject matter of any of Examples 14-20, and wherein the first dielectric has an atomic percentage of carbon that is greater than 5%.

Example 22 includes the subject matter of any of Examples 14-21, and wherein the first dielectric has an atomic percentage of oxygen that is greater than 20%.

Example 23 includes the subject matter of any of Examples 14-22, and further including a third dielectric in between and in contact with the source or drain and the first dielectric.

Example 24 includes the subject matter of any of Examples 14-23, and further including a nitride liner in contact with the source or drain and the third dielectric.

Example 25 includes the subject matter of any of Examples 14-24, and further including an integrated circuit die comprising the source or drain, the first dielectric, and the second dielectric.

Example 26 includes the subject matter of any of Examples 14-25, and further including a circuit board coupled to the integrated circuit die.

Example 27 includes the subject matter of any of Examples 14-26, and further including at least one of a network interface, battery, or memory coupled to the integrated circuit die.

Example 28 includes a method comprising forming a source or drain of a field effect transistor (FET); forming a first dielectric between a portion of the source or drain and a FET gate, the first dielectric comprising silicon nitride; and forming a second dielectric above at least a portion of the first dielectric, the second dielectric comprising silicon oxide doped with at least one of oxygen or carbon, the second dielectric having a dielectric constant lower than the first dielectric.

Example 29 includes the subject matter of Example 28, and further including forming a third dielectric on the second dielectric, the third dielectric comprising silicon nitride.

Example 30 includes the subject matter of any of Examples 28 and 29, and further including forming a conductive connection between the source or drain and the FET gate, wherein the conductive connection is formed in direct contact with the second dielectric.

Example 31 includes the subject matter of any of Examples 28-30, and further including forming a third dielectric formed within a recess in the second dielectric, the third dielectric comprising silicon nitride.

Example 32 includes the subject matter of any of Examples 28-31, and further including forming the second dielectric below and in contact with a conductive material connecting the source or drain to the gate.

Example 33 includes the subject matter of any of Examples 28-32, and wherein the source or drain is a source or drain of a first FET of a static random access memory (SRAM) cell and the gate is a gate of a second FET of the SRAM cell.

Example 34 includes the subject matter of any of Examples 28-33, and wherein the source or drain is a source or drain of a transistor and the gate is a gate of the same transistor.

Example 35 includes the subject matter of any of Examples 28-34, and wherein the second dielectric has an atomic percentage of nitrogen that is less than 20%.

Example 36 includes the subject matter of any of Examples 28-35, and wherein the second dielectric has an atomic percentage of carbon that is greater than 5%.

Example 37 includes the subject matter of any of Examples 28-36, and wherein the second dielectric has an atomic percentage of oxygen that is greater than 20%.

Example 38 includes the subject matter of any of Examples 28-37, and further including forming a third dielectric in between and in contact with the source or drain and the second dielectric.

Example 39 includes the subject matter of any of Examples 28-38, and further including forming a nitride liner in contact with the source or drain and the third dielectric.

Example 40 includes the subject matter of any of Examples 28-39, and further including forming an integrated circuit die comprising the source or drain, the first dielectric, and the second dielectric.

Example 41 includes the subject matter of any of Examples 28-40, and further including coupling a circuit board to the integrated circuit die.

Example 42 includes the subject matter of any of Examples 28-41, and further including coupling at least one of a network interface, battery, or memory to the integrated circuit die.

## Claims

1. An apparatus comprising:
a source or drain of a field effect transistor (FET);
a first dielectric between a portion of the source or drain and a FET gate, the first dielectric comprising silicon nitride; and
a second dielectric above at least a portion of the first dielectric, the second dielectric comprising silicon oxide doped with at least one of oxygen or carbon, the second dielectric having a dielectric constant lower than the first dielectric.

2. The apparatus of claim 1, further comprising a third dielectric formed within a recess in the second dielectric, the third dielectric comprising silicon nitride.

3. The apparatus of any of claims 1-2, wherein the second dielectric is below and in contact with a conductive material connecting the source or drain to the gate.

4. The apparatus of any of claims 1-3, wherein the source or drain is a source or drain of a first FET of a static random access memory (SRAM) cell and the gate is a gate of a second FET of the SRAM cell.

5. The apparatus of any of claims 1-3, wherein the source or drain is a source or drain of a transistor and the gate is a gate of the same transistor.

6. The apparatus of any of claims 1-5, wherein the second dielectric has an atomic percentage of nitrogen that is less than 20%.

7. The apparatus of any of claims 1-6, wherein the second dielectric has an atomic percentage of carbon that is greater than 5%.

8. The apparatus of any of claims 1-7, wherein the second dielectric has an atomic percentage of oxygen that is greater than 20%.

9. The apparatus of any of claims 1-8, further comprising a third dielectric in between and in contact with the source or drain and the second dielectric.

10. The apparatus of claim 9, further comprising a nitride liner in contact with the source or drain and the third dielectric.

11. The apparatus of any of claims 1-10, further comprising an integrated circuit die comprising the source or drain, the first dielectric, and the second dielectric.

12. The apparatus of claim 11, further comprising a circuit board coupled to the integrated circuit die.

13. The apparatus of any of claims 11-12, further comprising at least one of a network interface, battery, or memory coupled to the integrated circuit die.

14. A method of forming the apparatus of any of claims 1-13.
